Europäisches Patentamt

European Patent Office

Office européen des brevets

(11) Numéro de publication: **0 101 335**
**A1**

## (12) DEMANDE DE BREVET EUROPEEN

(21) Numéro de dépôt: **83401264.3**

(22) Date de dépôt: **17.06.83**

(51) Int. Cl.³: **H 01 L 23/56**
**H 01 L 23/04**

(30) Priorité: **29.06.82 FR 8211399**

(43) Date de publication de la demande:
**22.02.84 Bulletin 84/8**

(84) Etats contractants désignés:
**DE GB IT NL**

(71) Demandeur: **THOMSON-CSF**
**173, Boulevard Haussmann**
**F-75379 Paris Cedex 08(FR)**

(72) Inventeur: **Jarry, Jacques**
**THOMSON-CSF SCPI 173, bld Haussmann**
**F-75379 Paris Cedex 08(FR)**

(72) Inventeur: **Gloanec, Maurice**
**THOMSON-CSF SCPI 173, bld Haussmann**
**F-75379 Paris Cedex 08(FR)**

(74) Mandataire: **Taboureau, James et al,**
**THOMSON-CSF SCPI 173, Bld Haussmann**
**F-75379 Paris Cedex 08(FR)**

(54) **Microboîtier d'encapsulation de circuits intégrés logiques fonctionnant en très haute fréquence.**

(57) L'invention concerne un microboitier plat, à multisorties périphériques, de type céramique-métal, pour les circuits intégrés ultra-rapides tels que ceux sur GaAs par exemple.

Afin de faciliter l'insertion d'un circuit intégré ultra-rapide sur un substrat comportant un circuit électrique hyperfréquence, le microboitier selon l'invention comprend un cadre isolant (8) dont la face supérieure supporte des conducteurs du type ligne de transmission en microbandes (15) adaptées en impédance. Des microbandes épaisses (14), brasées sur les précédentes (15) constituent les connexions extérieures. Le cadre isolant (8) comprend en son centre une cavité (9) dans laquelle est logé le circuit intégré (10): les faces supérieures des microbandes (15) et du circuit intégré (10) sont dans le même plan. L'embase métallique (6) du boitier constitue le plan de masse.

Application à l'encapsulation des circuits intégrés logiques ultra-rapides constituant les composants clés utilisés en télécommunication, en avionique, en informatique et en instrumentation.

FIG. 3

## MICROBOITIER D'ENCAPSULATION DE CIRCUITS INTEGRES LOGIQUES FONCTIONNANT EN TRES HAUTE FREQUENCE

L'invention concerne un microboitier multisorties d'encapsulation des circuits intégrés ultra-rapides fonctionnant en très haute fréquence, c'est-à-dire supérieures ou égales à 2 GHz. Les circuits intégrés intéressés par le boitier selon l'invention sont ceux qui sont réalisés ici sur des matériaux semiconducteurs du type arséniure de gallium, utilisés dans les circuits de logique ultra-rapides. Le microboitier multisorties selon l'invention présente des caractéristiques n'altérant pas le fonctionnement électrique du circuit intégré encapsulé.

Les circuits intégrés encapsulés dans le microboitier selon l'invention sont essentiellement les nouveaux circuits intégrés réalisés sur des matériaux tels que l'arséniure de gallium GaAs, l'arséniure de gallium alumi-nium GaAlAs, et autres matériaux semiconducteurs plus généralement des familles III-V et II-VI. Ce sont des circuits ultra-rapides ayant des fréquences de coupure qui atteignent ou dépassent 30 GHz, et ils seront dénommés, dans la suite de ce texte sous l'appellation prise dans son sens le plus vaste, de circuits ultra-rapides ou de circuits sur GaAs, en opposition avec les circuits intégrés classiques, sur silicium, dont les fréquences de fonctionnement sont généralement inférieures à 1 GHz.

En effet, alors que les circuits intégrés sur silicium sont, grosso-modo, limités en dessous de 1 GHz en fréquence de fonctionnement, les circuits intégrés logiques sur arséniure de gallium fonctionnent jusqu'à la bande X (8 GHz), et les composants discrets qui leur sont parfois associés, tels que les diodes, peuvent fonctionner jusque 100 GHz. Il est connu qu'à très hautes fréquences, les liaisons ou l'interface entre les composants actifs doivent être de natures différentes des liaisons entre composants pour les circuits "classiques", fonctionnant entre le continu et 1 GHz au maximum. Dans le cas des circuits classiques les liaisons se font au moyen de lignes conductrices métalliques de formes quelconques, qui, moyennant quelques précautions élémentaires, ne déforment pas le signal ; au contraire sont utilisés dans les très hautes fréquences des liaisons telles que guides d'ondes ou lignes microbandes, très soigneusement étudiées pour ne pas dégrader le signal, par élimination des inductances et capacités parasites qui sont facilement introduites en hyperfréquence.

Ainsi, selon l'art connu, un circuit intégré classique sur silicium est encapsulé dans un microboitier, de type plastique ou céramique, ou encore céramique-métal, dans lequel les liaisons entre la pastille du circuit intégré et le circuit extérieur sont assurées par un réseau dit "araignée" qui est soit sérigraphié sur le substrat ou sur le fond du boitier, soit découpé dans une feuille métallique. La forme des bandes métalliques constituant l'araignée, le rapport de leur épaisseur sur leur largeur, leur résistance important peu aux fréquences inférieures à 1 GHz : ce sont des conducteurs électriques, au même titre que les pistes conductrices sur un circuit imprimé ou un circuit hybride, dont on sait que ces pistes peuvent se croiser à des niveaux différents, pour constituer un circuit multicouches.

En outre, la pastille d'un circuit intégré classique est très généralement fixée sur le même plan supérieur du fond de boitier que les bandes métalliques de l'araignée des liaisons. Ce qui signifie que, sauf exception, la face supérieure de la pastille d'un circuit intégré classique et la face supérieure des bandes de métal ne sont pas dans le même niveau, et que les fils d'or de "couture" de la pastille sont de longueur et de forme adaptées pour relier deux plans dans des niveaux différents.

Ce qui n'a pas d'importance pour des circuits basse fréquence, en dessous de 1 GHz, et sur silicium, a de l'importance pour des circuits à très haute fréquence fonctionnant au dessus de 2 GHz tels que des circuits intégrés logiques réalisés sur GaAs.

L'invention résout ce problème de l'encapsulation des circuits intégrés ultra-rapides et de leur interface avec le reste du circuit à très haute fréquence, sans détérioration des caractéristiques des informations électriques transmises, et sans dégradation des performances intrinsèques du circuit intégré à encapsuler. L'invention propose un boitier d'encapsulation de très petites dimensions, étanche, de type céramique ou céramique-métal, dans lequel les performances électriques du circuit intégré encapsulé sont sauvegardées par un compromis qui minimise les éléments parasites et réduit les couplages entre connexions d'accès extérieur. Ce résultat et

3

l'adaptation du boitier au circuit intégré ultra-rapide encapsulé est obtenu parce que le boitier selon l'invention est un boitier du type microboitier plat céramique, dans lequel l'interface ou, ce qui revient au même, les liaisons électriques entre la pastille de circuit intégré encapsulée et le réseau extérieur, est assuré par des lignes de transmission fonctionnant selon le modèle dit des micro-bandes, également connues sur leur appellation anglaise de "microstrip", et parce que le circuit intégré est situé dans une cuvette pratiquée dans une plaque céramique, cette plaque ayant une épaisseur égale à l'épaisseur de la pastille d'arséniure de gallium sur laquelle est réalisé le circuit intégré, de telle sorte que les microbandes sont au même niveau que la face supérieure de la pastille de circuit intégré, ce qui minimise la désadaptation entre circuits intégrés et réseaux extérieurs.

De façon plus précise, l'invention concerne un microboitier d'encapsulation de circuits intégrés logiques fonctionnant en très haute fréquence, du type boitier plat à connexions externes périphériques, comportant une embase, un cadre isolant et un cadre d'épaisseur supportant un couvercle, caractérisé en ce que le cadre isolant comporte en son centre une cavité dans laquelle est placée la pastille de circuit intégré, et en ce que la liaison électrique entre une métallisation de prise de contact de la pastille de circuit intégré et le réseau extérieur correspondant est assurée par une ligne de transmission du type ligne micro-bande adaptée en impédance, cette ligne de transmission étant constituée par une première micro-bande portée par la face supérieure du cadre isolant et par une seconde micro-bande, brasée sur la première et formant connexion externe, l'embase métallique formant plan de masse pour la ligne de transmission micro-bande adaptée.

L'invention sera mieux comprise par la description d'un exemple de réalisation et de quelques unes de ses variantes, cette description s'appuyant sur les figures jointes en annexe et qui représentent :

- figure 1 : boitier d'encapsulation de circuits intégrés hautes fréquences selon l'art connu

- figure 2 : vue en coupe d'un microboitier selon l'invention

- figure 3 : vue en plan d'un microboitier selon l'invention

- figure 4 : vue de détail montrant la position d'une pastille de circuit intégré dans un boitier selon l'art connu

4

- figure 5 : vue de détail montrant la position d'une pastille de circuit intégré ultra-rapide dans un boitier selon l'invention

- figure 6 : vue en plan d'un microboitier selon l'invention dans une variante de configuration des microbandes

- figure 7 : courbes d'atténuation de deux modèles de microboitiers selon l'invention

- figures 8 et 9 : courbes des temps de transition de deux modèles de microboitiers selon l'invention.

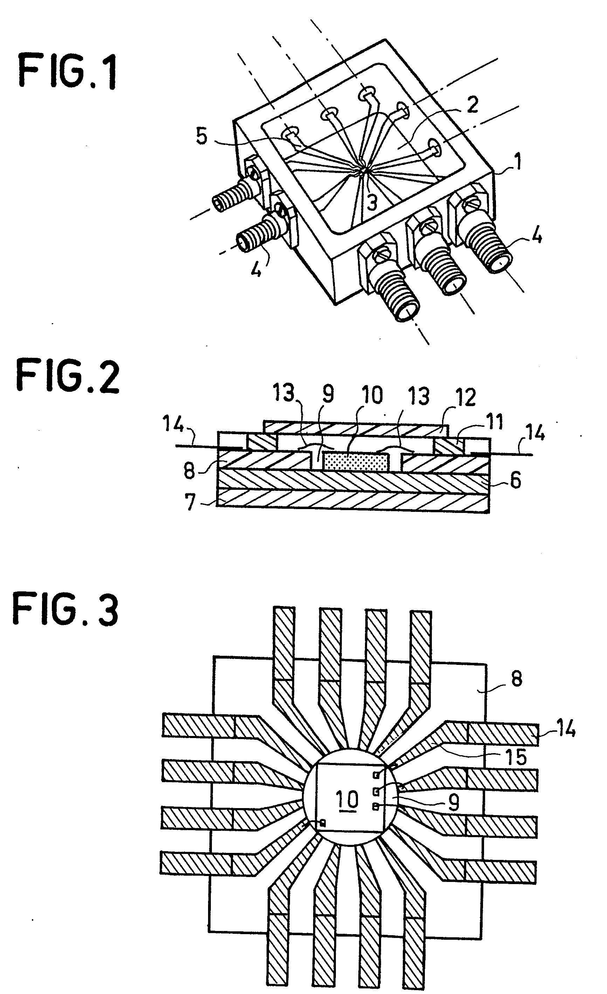

La figure 1 représente une vue de trois quart dans l'espace d'un boitier d'encapsulation de circuits intégrés ultra-rapides, du type de ceux qui sont utilisés dans les laboratoires pour intégrer un tel circuit dans un ensemble plus complexe.

Ce boitier est constitué par un bloc métallique 1, généralement en cuivre, qui a été usiné pour y former une cavité. Le fond plan de cette cavité est occupé par une plaque 2 de matière isolante, céramique ou oxyde de béryllium, sur laquelle est rapportée la pastille 3 du circuit intégré. Les faces extérieures du boitier 1, qui a très naturellement la forme d'un parallélépipède, supportent des connecteurs coaxiaux 4 et chaque plot métallique de sorties, sur la pastille du circuit intégré 3, est relié à chaque connecteur coaxial 4 par une bande métallique suspendue 5. Les connecteurs coaxiaux sont adaptés en impédance, mais il n'en demeure pas moins que, en raison de l'encombrement des connecteurs coaxiaux, par rapport aux dimensions d'une pastille de circuit intégré, ce boitier est très volumineux. Ce type de boitier présente d'excellentes caractéristiques de transfert, c'est-à-dire qu'il dégrade peu la forme du signal transmis par le circuit intégré, capacités et inductances parasites restent faibles, mais au prix d'un boitier très volumineux et très coûteux.

Le boitier de la figure 1 est refermé par un couvercle, ce qui fait que l'étanchéïté n'est pas nécessairement parfaite et que demeurent des risques de corrosion de la pastille de circuit intégré par les gaz présents à l'intérieur du boitier ou qui peuvent s'y introduire, sauf précautions coûteuses.

De plus, ce modèle de boitier n'est pas dans la ligne de la technologie des circuits intégrés et il est difficile à rapporter sur un circuit plus complexe qui, outre le circuit intégré, comporte par exemple des micro- bandes, des résonnateurs et d'autres objets tous réalisés selon une technologie plane : par exemple il faut repartir de chaque connecteur coaxial 4 avec le connecteur coaxial correspondant mâle ou femelle selon le cas pour revenir sur un circuit imprimé ou un circuit hybride. Il y a donc une rupture d'homogénéité dans la technologie employée.

En outre, ceci n'est pas négligeable, le prix d'un tel boitier est prohibitif et s'oppose à un développement massif de la microélectronique ultra-rapide.

C'est pour résoudre ces difficultés et ces inhomogénéités dans la technologie qu'un boitier d'encapsulation de type plat, céramique, étanche, et électriquement performant a été mis au point.

La figure 2 représente une vue en coupe d'un microboitier pour circuits ultra-rapides selon l'invention.

L'invention sera exposée en s'appuyant sur le cas d'un microboitier multisorties dont les sorties sont périphériques, et ce boitier ressemble à un boitier plat connu sous l'appellation anglaise de "flat-pack", mais ceci ne limite nullement l'invention qui s'applique à des microboitiers ayant un nombre de sorties différentes de ce qui est représenté, dont les sorties peuvent tout aussi bien être disposées en ligne, comme dans les boitiers linéaires connus sous le nom anglais de "dual in line", et dont les matériaux de réalisation pourraient être éventuellement différents.

Un microboitier selon l'invention comporte une base constituée de deux pièces métalliques. La première pièce métallique est une semelle 6, choisie parmi les métaux offrant une excellente conductibilité thermique, tel que le cuivre, puisque c'est cette semelle 6 qui reçoit le circuit intégré et qui dissipe la chaleur dégagée au cours du fonctionnement. La seconde pièce métallique est une seconde semelle 7, choisie parmi les métaux permettant de compenser les contraintes thermiques dûes au coefficient de dilatation, contraintes engendrées par les différences de dilatation des constituants du microboitier, au cours du fonctionnement.

La partie haute du microboitier selon l'invention comporte un cadre 8, en céramique mais préférentiellement en alumine, posé sur la semelle 6 de dissipation thermique. Ce cadre 8 comporte dans sa partie centrale un évidement 9 qui constitue, en liaison avec la semelle thermique 6, une cavité dans laquelle le circuit intégré 10 est fixé. Les dimensions de la cavité 9 sont telles qu'elles permettent au circuit intégré 10 d'être placé dans la cavité pour des raisons qui seront décrites ultérieurement. De même, l'épaisseur de cadre 8 est égale ou très sensiblement égale à l'épaisseur de la pastille 10 de circuit intégré. Sur le cadre 8, sont déposées des microbandes, métalliques, qui servent de connexions externes au circuit intégré 10 : ces microbandes seront détaillées ultérieurement.

Enfin, le microboitier selon l'invention est achevé au moyen d'un cadre 11, qui confère au microboitier une certaine épaisseur permettant de dégager le circuit intégré à l'intérieur du microboitier, et par un couvercle 12. Le cadre 11 et le couvercle 12 sont tous deux en céramique, tel que l'alumine, et métallisés sur les parties par lesquelles cadre 11 et couvercle 12 sont brasés sur le cadre 8. Mais de plus, le couvercle 12 est recouvert par une couche métallique résistive, de façon à créer une ligne amortie entre les différentes connexions d'entrées sorties du circuit intégré conformément à la demande de brevet enregistrée sous le N° 81 09 935 de la Demanderesse. Des liaisons 13, les plus courtes possible assurent la continuïté électrique entre les plots métalliques portés par la surface supérieure de la pastille 10 de circuit intégré et les microbandes 15.

L'ensemble du microboitier est assemblé par brasure à haute température de la semelle thermique 6 sur la semelle de compensation 7, puis par brasure des différents cadres céramique 8 et 11 et du couvercle céramique 12 sur l'embase métallique et les uns sur les autres : bien évidemment les précautions évidentes pour l'homme de l'art sont prises pour que la brasure du cadre 11 sur le cadre 8 ne court-circuite pas entre elles les connexions extérieures 14 et 15.

Les microboitiers à multisorties périphériques selon l'invention sont réalisés à partir de céramiques dont la teneur en alumine est égale ou supérieure à 92 % selon la méthode adoptée pour le dépôt des métallisations, c'est-à-dire des connexions internes 15. Les propriétés électriques du microboitier, c'est-à-dire sa fonction de transfert et la façon dont il préservera les informations électriques transmises par le circuit intégré, sont fonction de la constante diélectrique du support et de l'impédance caractéristique des lignes de transmission. Le choix du substrat est le plus souvent issu d'un

7

compromis entre la qualité du boitier à obtenir et les méthodes de fabrication utilisées. Les méthodes de dépôt des microbandes qui constituent les connexions extérieures sont la technique de couches minces déposées sous vide et gravées, ou la technologie de couches épaisses sérigraphiées, selon la technique retenue pour usiner et assembler les différentes pièces constituant le boitier. A titre d'exemple non limitatif, alors que le boitier représenté en figure 1 et qui comporte 10 connexions d'accès par connecteurs coaxiaux a des dimensions extérieures de 30 mm x 30 mm, le microboitier selon l'invention a des dimensions extérieures de 7 mm x 7 mm pour 8 connexions d'accès et de 8,5 x 8,5 mm pour 16 connexions d'accès, et il permet de recevoir un circuit intégré dont la pastille a de l'ordre de 2 mm de côté.

Les figures suivantes, 3 et 5 notamment permettent de mieux expliciter le détail des liaisons entre la pastille de circuit intégré 10 et les accès extérieurs.

La figure 3 représente une vue en plan d'un microboitier pour circuit intégré ultra-rapide selon l'invention. Le couvercle 12 en est ôté de façon à laisser voir apparaître l'intérieur du microboitier.

Le cadre céramique 8 est percé en son centre d'un alèsage 9 dont les dimensions sont adaptées à celles de la pastille 10 de circuit intégré à y insérer. La face supérieure de ce cadre céramique 8 supporte l'araignée des liaisons, mais ces liaisons ne sont pas constituées comme dans les boitiers de circuits intégrés à basse fréquence par des dépôts ou par des bandes métalliques de formes quelconques et d'impédances quelconques : en effet, ce boitier fonctionne en mode de transmission de type microbandes, c'est-à-dire que les liaisons intérieures 9 sont des microbandes adaptées en impédance, qu'elles ont donc une largeur et une épaisseur déterminées, et que leur impédance est normalisée, 50 Ohms étant la normalisation la plus fréquente. Ces microbandes 15 sont comme il a été dit déposées par la technologie de couches minces ou par la technologie de couches épaisses, c'est-à-dire qu'elles sont limitées à la surface supérieure du cadre 8 : elles sont donc prolongées par des microbandes 14 brasées sur les microbandes 15, les microbandes 14, extérieures au cadre 8, constituent les connexions de sorties du microboitier.

Etant donné les très petites dimensions du microboitier et la très haute fréquence de fonctionnement du circuit intégré encapsulé dans ce microboitier, il y a accroissement de la capacité parasite entre les micro-bandes 15 à proximité de l'alèsage 9, lorsque les microbandes se ressèrrent sur le périmètre de l'alèsage central. C'est pourquoi, tout en conservant un mode de transmission adapté en impédance à la fréquence de travail, les microbandes 15 sont, dans le cas de la figure 3, constituées non pas de bandes dont les deux bords sont parallèles entre eux, mais par un compromis trouvé entre l'adaptation en impédance et la minimisation de capacité parasite, les bords des microbandes 15 étant légèrement convergents vers le centre du microboitier.

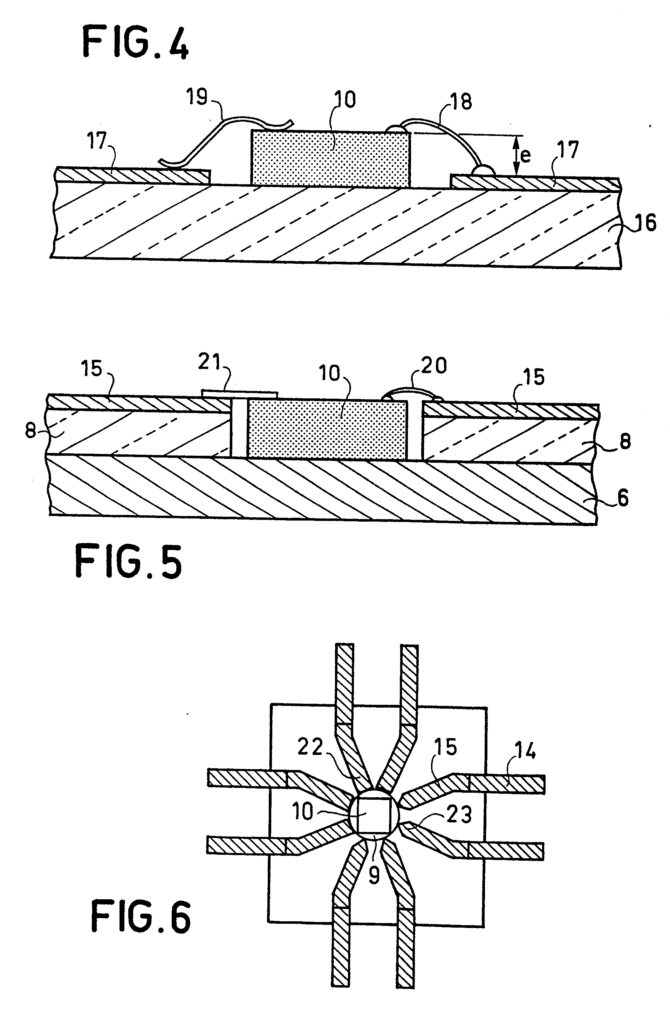

Chaque extrémité d'une microbande, située à proximité de l'alèsage 9, et chaque plot de métallisation correspondant, à la surface supérieure de la pastille 10 de circuit intégré, sont reliés par un fil ou une bande métallique, la plus courte possible, de façon à limiter l'effet d'inductance parasite, et ceci est possible en raison d'un alèsage 9 qui permet d'avoir dans un même plan ou très sensiblement dans un même plan les surfaces supérieures des microbandes 9 et de la pastille de circuit intégré 10. C'est cette liaison qui est développée et expliquée par les figures 4 et 5.

La figure 4 représente une vue de détail montrant la position d'une pastille de circuit intégré dans un boitier selon l'art connu.

Sur un support 16, qui est un substrat ou un fond de boitier, sont fixées d'une part la pastille 10 de circuit intégré et d'autre part l'araignée 17 des connexions extérieures. Etant donné les fréquences relativement basses, c'est-à-dire qui s'expriment en MHz, auxquelles fonctionne dans le cas présent ce circuit intégré, il n'est pas nécessaire de prendre de précaution pour adapter en impédance les liaisons d'accès extérieur 17, et pour lutter contre les capacités et les inductances parasites. Ainsi, et sauf cas fortuits, il y a en général une différence de niveau entre la face supérieure de la pastille 10 de circuit intégré et la face supérieure des bandes métalliques 17 qui constituent les liaisons externes. Cet écart noté "e" entre les faces supérieures des objets à relier ensemble par une liaison électrique entraîne une plus grande longueur, et éventuellement une distortion de ces liaisons électriques.

C'est ainsi que sur la partie droite de la figure 4 est représentée une liaison faite par un fil d'or 18 soudé par échauffement et écrasement, selon la technologie connue en anglais sous l'appellation de "ball-bonding". Cette liaison par un fil d'or 18 a naturellement une forme recourbée, due au principe même du report de fil d'or, mais elle est également plus longue que si les faces supérieures de la pastille et de la métallisation 17 étaient au même niveau, c'est-à-dire si on avait e = 0.

De la même façon sur la partie gauche de la figure 4 est représenté un autre type de liaison, obtenu soit par un fil d'or ou d'aluminium soit par une bande ou une feuille 19 soudée par ultrasons, c'est-à-dire écrasée à plat sur la surface supérieure de la pastille 10 et la surface supérieure de la liaison 17. La géométrie de cette couture est légèrement différente, a une forme en "S" mais est de toute façon comme la précédente couture 18 relativement longue du fait de la différence entre les niveaux des surfaces supérieures de la puce et de la liaison.

La figure 5 représente une vue de détail montrant la position d'une pastille de circuit intégré ultra-rapide dans un boitier selon l'invention.

Sur la semelle thermique 6, est fixée la pastille 10 de circuit intégré ultra-rapide, et les microbandes accordées 15 sont supportées par la face supérieure de la plaque de céramique 8, dont il a été dit qu'elle comporte en son centre une cuvette de dimensions un peu supérieures aux dimensions de la pastille et qu'en outre l'épaisseur de la plaque isolante 8 est égale à celle de la pastille, de telle sorte que la surface supérieure de la pastille 10 et la face supérieure de la plaque 8, ou ce qui revient presque au même la face supérieure des microbandes 15, lesquelles sont très minces, sont sensiblement dans le même plan. Ainsi, la liaison électrique nécessaire entre les plots métalliques portés par la pastille 10 et les microbandes 15 se fait au plus court soit par un fil 20 soudé par fusion et formation d'une boule (ball-bonding), soit par une feuille 21 soudée par ultrasons. La comparaison entre la figure 4 et la figure 5 montre, même si l'échelle des dimensions réelles n'est pas respectée, que la liaison dans le cas du boitier selon l'invention est beaucoup plus courte que la liaison dans le cas des boitiers classiques, et que par conséquent la perturbation apportée dans la transmission d'un signal à très haute fréquence, ou plus exactement la désadaptation entre le circuit intégré et le réseau des liaisons externes, est minimisé.

La figure 6 représente une vue en plan d'un microboitier selon l'invention, dans une variante de configuration des microbandes. Ce type de variantes est possible lorsque le nombre de connexions externes exigé par le circuit intégré encapsulé n'est pas trop élevé.

Il a été dit, à l'occasion de la figure 3, qu'un compromis a été adopté entre la configuration des microbandes 15, dont les bords sont normalement parallèles, et le couplage des liaisons entre elles qui donnent des capacités parasites. Ce compromis consiste en microbandes dont les bords sont légèrement convergents vers le centre du boitier. Si le nombre de liaisons extérieures exigées par le circuit intégré ultra-rapide n'est pas trop élevé, il est possible de donner aux microbandes accordées une configuration qui respecte mieux l'adaptation, en leur conservant des bords parallèles entre eux, avec deux extrémités possibles qui ont été toutes deux représentées sur la même figure 6. Sur cette figure, certaines bandes telles que 22 ont une géométrie rectangulaire à leur extrémité proche de la pastille de circuit intégré. D'autres bandes 23 ont une extrémité qui est légèrement affinée, de façon à ne pas créer de capacités parasites entre bandes voisines et à ne pas désadapter le circuit

Le tableau ci-dessous permet de comparer les caractéristiques élémentaires entre un microboitier plat connu du type "flat-pack", un boitier à microbandes suspendues tel que décrit en figure 1 et le microboitier selon l'invention, dans deux versions à 8 et 16 sorties.

| | Boitier plat connu | Boitier microbandes suspendues (fig.1) | Boitier selon invention | |
|---|---|---|---|---|
| | | | 8 sorties | 16 sorties |
| Dimensions mm | 4,5 x 4,5 | 30 x 30 | 7 x 7 | 8,5 x 8,5 |
| Nombre de sorties | 10 | 10 | 8 | 16 |
| Valeur du découplage entre sorties (avec une ligne écran) | | | | |
| à 1 GHz | 30 dB | 50 dB | 46 dB | 39 dB |
| à 5 GHz | − | 34 dB | 26 dB | 26 dB |

L'examen des performances comparées montre que si la valeur de découplage des microboitiers selon l'invention est inférieure à celle d'un boitier du type à microbandes suspendues, elle reste néanmoins très correcte à 5 GHz (supérieure ou égale à 25 dB) et très supérieure à celle des boitiers plats commerciaux connus sous l'appellation anglaise de "flat-pack".

La figure 6 donne les performances en transmission du boitier selon l'invention.

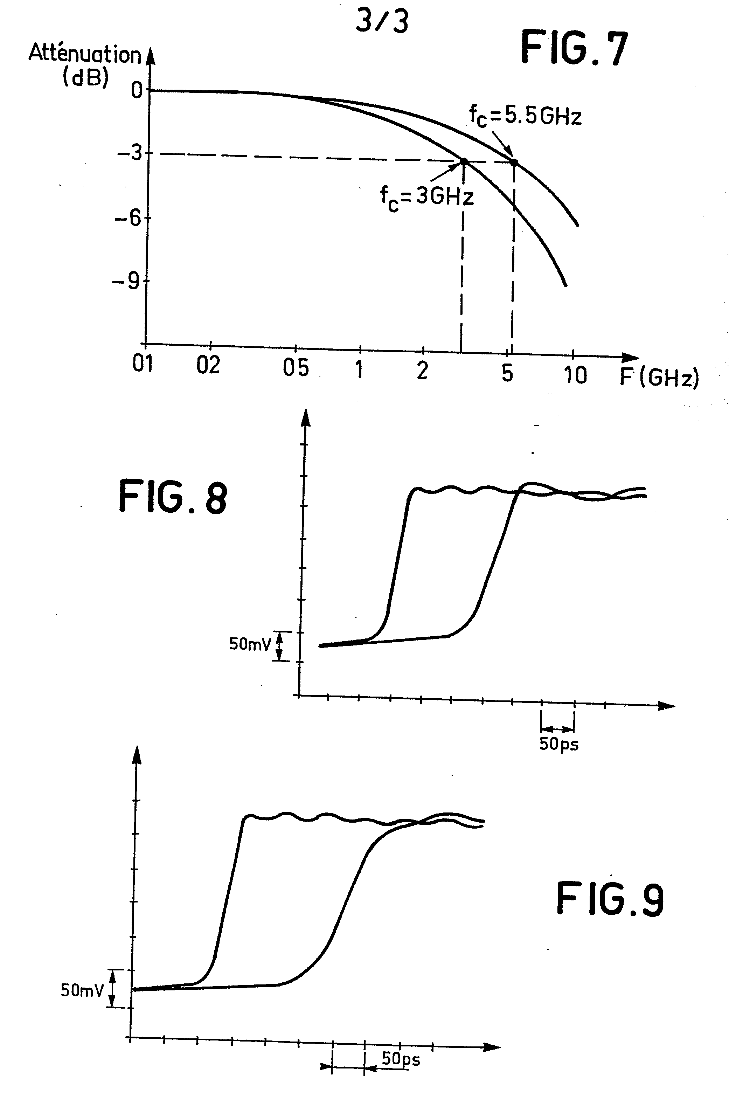

L'atténuation en décibels étant donnée en ordonnée et la fréquence de fonctionnement en GHz étant portée en abscisse, selon une échelle logarithmique, la courbe supérieure est relative à un boitier à 8 connexions d'entrée-sorties et la courbe inférieure est relative à un boitier à 16 connexions d'entrées-sorties. On voit que la fréquence de coupure relevée pour une atténuation de - 3 dB est de 5,5 GHz pour un boitier 8 connexions et 3 GHz pour un boitier à 16 connexions. Les performances en transmission étant liées à la longueur des connexions de liaisons (inductance des fils de liaisons) et à la qualité des conducteurs (désadaptation en fréquence, soudure et fil de soudure... etc), le microboitier selon l'invention présente d'excellentes spécifications puisque, pour des fréquences de coupures de 5,5 et de 3 GHz respectivement pour les boitiers à 8 et à 16 connexions, ils ont des temps de montée respectifs de 63 et 92 picosecondes ainsi que le montrent les figures 8 et 9 qui concernent respectivement un boitier à 8 connexions pour la figure 8 et un boitier à 16 connexions pour la figure 9. Le temps de montée d'un signal transmis est donné par la relation $T_M = \sqrt{T^2_{M_E} + T^2_{M_B}}$ avec $T_{M_E}$ = le temps de montée à l'entrée d'un signal appliqué, et $T_{M_B}$ = le temps de montée du boitier proprement dit. Ces chiffres démontrent la cohérence obtenue entre les performances des boitiers encapsulant et celles des composants à encapsuler, ceux-ci travaillant à des fréquences de quelques GHz sur des signaux présentant des temps de transition de 50 à 200 picosecondes.

A titre indicatif, pour le boitier 16 sorties, sans que ces détails ne limitent en quoi que se soit la portée de l'invention, les conducteurs en microbandes adaptées 15 et les connexions externes 14 sont de largeur de 0,6 mm, au pas de 1,5 mm, déposés sur un cadre céramique 8 de 0,6 mm d'épaisseur. Ces microbandes ont une impédance caractéristique adaptée de 50 Ohms, et elles sont réduites en largeur vers le centre du boitier afin de s'affranchir au maximum des couplages entre sorties. Elles sont optimisées au plus près des métallisations d'accès du circuit intégré à encapsuler de façon à diminuer les inductances parasites et à améliorer les temps de transition en transmission (L $\leqslant$ 1 nH).

Le couvercle 12 est comme il a été dit en céramique recouverte d'une couche résistive qui constitue un plan de masse fictif, le plan de masse fictif du couvercle, le plan de masse de la plaque 6 d'évacuation thermique et le plan des connexions constituant ainsi un effet triplaque, destiné à compenser la désadaptation dans les liaisons du circuit. Le microboitier selon l'invention a été décrit en s'appuyant sur des cas précis dans lesquels la semelle thermique 6 est en cuivre et le cadre céramique en alumine. Des connexions externes au nombre de 8 et de 16 ont été citées, mais ces précisions ne limitent pas le domaine de l'invention qui s'applique d'une façon plus générale à un microboitier dont les liaisons entre le circuit intégré ultra-rapide encapsulé et le réseau externe sont assurées par des microbandes adaptées en impédance. Le nombre de sorties, la constitution des matériaux et d'autres détails de réalisation qui sont évidents pour l'homme de l'art ne limitent pas la portée de l'invention qui s'applique au domaine des très hautes fréquences.

Dans les télécommunications par exemple, ce domaine d'application nécessitant l'utilisation de fréquences de transmission et des impulsions extrêmement courtes dont les temps de montée et de descente sont de l'ordre de 100 picosecondes, il est nécessaire d'éliminer au maximum l'incidence du montage et des interconnexions d'un circuit intégré ultra-rapide, cette incidence étant liée directement à la vitesse de fonctionnement des composants ultra-rapides.

Le microboitier selon l'invention est précisé par les revendications suivantes.

## REVENDICATIONS

1. Microboitier d'encapsulation de circuits intégrés logiques fonctionnant à très haute fréquence, du type boitier plat à connexions externes périphériques, comportant une embase (6 + 7), un cadre isolant (8) et un cadre d'épaisseur (11) supportant un couvercle (12), caractérisé en ce que le cadre isolant (8) comporte en son centre une cavité (9) dans laquelle est placée la pastille (10) de circuit intégré, et en ce que la liaison électrique entre une métallisation de prise de contact de la pastille de circuit intégré et le réseau extérieur correspondant est assurée par une ligne de transmission du type ligne microbande adaptée en impédance, cette ligne de transmission étant constituée par une première microbande (15) portée par la face supérieure du cadre isolant (8) et par une seconde microbande (14), brasée sur la première (15) et formant connexion externe, l'embase (6) métallique formant plan de masse pour la ligne de transmission microbande adaptée.

2. Microboitier d'encapsulation selon la revendication 1, caractérisé en ce que la face supérieure des lignes microbandes (15) et la face supérieure de la pastille (10) de circuit intégré sont dans le même plan et en ce que la cavité (9) dans le cadre isolant (8) est de dimensions minimales pour y loger la pastille (10) de circuit intégré, la liaison entre une métallisation de prise de contact sur la pastille (10) de circuit intégré et l'extrémité correspondante d'une ligne microbande étant effectuée par un fil métallique (13) de longueur minimale, présentant une faible désadaptation.

3. Microboitier d'encapsulation selon la revendication 1, caractérisé en ce que, en vue de minimiser les couplages entre lignes de transmission, les microbandes (15) sont réduites en largeur vers le centre du boitier.

4. Microboiter d'encapsulation selon la revendication 1, caractérisé en ce que les microbandes (15) ont leurs bords parallèles entre eux sur la majeure partie de la longueur de la microbande, laquelle se termine en pointe (23) vers le centre du boitier.

5. Microboitier d'encapsulation selon la revendication 1, caractérisé en ce que l'embase métallique (6), sur laquelle sont brasés le cadre isolant (8) et

14

la pastille (10) de circuit intégré, formant un premier plan de masse, le couvercle (12) en céramique recouverte d'une couche résistive forme un second plan de masse par rapport aux lignes de transmission en hyperfréquences que constituent les microbandes (15) adaptées.

6. Microboitier d'encapsulation selon l'une quelconque des revendications 1 à 5 caractérisé en ce que, dans une configuration à 8 connexions d'accès, sa fréquence de coupure est égale à 5,5 GHz.

7. Microboitier d'encapsulation selon l'une quelconque des revendications 1 à 5 caractérisé en ce que, dans une configuration à 16 connexions d'accès, sa fréquence de coupure est égale à 3 GHz.

FIG.1

FIG.2

FIG.3

**FIG.4**

**FIG.5**

**FIG.6**

3/3

0101335

FIG.7

FIG.8

FIG.9

Office européen
des brevets

**RAPPORT DE RECHERCHE EUROPEENNE**

EP    83 40 1264

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| X | FR-A-2 244 264  (NIPPON ELECTRIC) <br> * figure 13; revendications 1,6; page 15, lignes 25-28 * | 1,2 | H 01 L   23/56 <br> H 01 L   23/04 |
| | --- | | |
| X | FR-A-2 263 606  (RCA) <br> * figures  1,5; revendication 1; page 2, lignes 18-19 * | 1,2,5 | |
| | --- | | |
| A | FR-A-2 299 724  (HONEYWELL) <br> * figure 1 * | 3,4 | |
| | ----- | | |

|  | **DOMAINES TECHNIQUES RECHERCHES (Int. Cl. ³)** |
|---|---|
|  | H 01 L |

Le présent rapport de recherche a été établi pour toutes les revendications

| Lieu de la recherche <br> LA HAYE | Date d'achèvement de la recherche <br> 12-10-1983 | Examinateur <br> DE RAEVE R.A.L. |
|---|---|---|

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons

&  : membre de la même famille, document correspondant

OEB Form 1503. 03.82